# EUROPÄISCHE PATENTSCHRIFT

(11) **EP 2 029 937 B1**
(45) Veröffentlichungstag und Bekanntmachung des Hinweises auf die Patenterteilung: **13.02.2019**
(21) Anmeldenummer: 07729844.6
(22) Anmeldetag: 04.06.2007
(51) Int. Cl.: F21V 31/03

(54) **LUFTDURCHLÄSSIGES VERSCHLUSSELEMENT FÜR GESCHLOSSENE GERÄTE**
AIR-PERMEABLE CLOSURE ELEMENT FOR CLOSED UNITS
ELEMENT DE FERMETURE PERMEABLE A L'AIR POUR APPAREILS FERMES

(30) Priorität: 02.06.2006 DE 202006008917 U
(43) Veröffentlichungstag der Anmeldung: 04.03.2009
(73) Patentinhaber: Oxyphen AG, 8853 Lachen (CH)
(72) Erfinder: KLUGE, Frank, 02956 Rietschen (DE); HEINZELMANN, Christian, 01833 Stolpen (DE)
(74) Vertreter: Lippert Stachow Dresden
(86) Internationale Anmeldenummer: PCT/EP2007/055456
(87) Internationale Veröffentlichungsnummer: WO 2007/141232

(56) Entgegenhaltungen:
- WO-A-96/16288
- WO-A-2006/031735
- DE-A1- 19 726 328
- DE-A1- 19 756 199
- JP-A- 2005 150 376
- US-B1- 6 524 361

## Beschreibung

Die Erfindung betrifft ein luftdurchlässiges Verschlusselement für geschlossene Geräte mit einer Filterscheibe, einem die Filterscheibe überdeckenden Abdeckelement und einer aus einem Elastomer bestehenden Dichtung.

Die Erfindung betrifft auch ein luftdurchlässiges Verschlusselement für geschlossene Geräte mit einer Filterscheibe, einem die Filterscheibe überdeckenden Abdeckelement und einer aus einem Elastomer bestehenden Dichtung, wobei das Abdeckelement eine Öffnung aufweist, die durch eine Deckelseite einseitig verschlossen ist und die eine Innenseite des Abdeckelementes bildet.

Geschlossene Geräte, wie beispielsweise Scheinwerfer, Elektronik-Steuergeräte, weisen in ihrem Inneren meist Wärmequellen auf. Diese Wärmequellen führen zu einer Ausdehnung der Luft im Inneren des Gehäuses. Daraus resultiert ein Luftaustausch. Um zu vermeiden, dass durch diesen Luftaustausch Umweltschmutz in das Innere des Gehäuses gelangt, besteht eine Möglichkeit darin, das Gehäuse hermetisch dicht zu gestalten und dadurch den Luftaustausch gänzlich zu verhindern. Da teilweise jedoch durch die Ausdehnung erhebliche Drücke entstehen können, erfordert ein hermetischer Verschluss einen erheblichen technologischen und mechanischen Aufwand.

Eine andere Möglichkeit besteht darin, den Gehäuseinnenraum zu belüften beziehungsweise einen Gasaustausch zu erlauben. Ein erlaubter Gasaustausch erfordert es jedoch, dass Maßnahmen getroffen werden, durch die Umwelteinflüsse von dem Innenraum des geschlossenen Gerätes fern gehalten werden.

Üblicherweise wird dazu der Innenraum des geschlossenen Gerätes dicht gestaltet und nur in klar definierten Stellen werden gezielt Belüftungsöffnungen eingebracht. Diese Belüftungsöffnungen werden dann mit einem luftdurchlässigen Verschlusselement verschlossen. Die Vermeidung von Umwelteinflüssen wird dabei dadurch bewerkstelligt, dass das Verschlusselement mit einer Filterscheibe versehen ist, durch die ein Gasaustausch möglich ist, die jedoch zumindest Staubpartikel nicht durchlässt. Die Belüftungsöffnungen bestehen aus zumeist kreisrunden Löchern in der Gehäusewand. In diese Löcher können die Verschlusselemente eingesteckt werden. Die Löcher können jedoch auch mit einem Dom versehen werden, auf den ein Verschlusselement aufgesteckt werden kann.

Ein solches Verschlusselement ist beispielsweise in der US 5 522 769 beschrieben. Dieses Verschlusselement dient dem Einstecken in eine Belüftungsöffnung. Es besteht aus einem Grundkörper, in dem eine Durchgangsöffnung eingebracht ist, im Verlaufe deren Längserstreckung eine quer liegende Filterscheibe zwischengeschaltet ist. Diese Lösung zeigt das grundlegende Problem, dass nicht nur Staubpartikel bei dem Luftaustausch von dem Innenraum des Gehäuses fernzuhalten sind, sondern auch Wasser. Beispielsweise beim Einsatz eines solchen Verschlusselementes in einem Kraftfahrzeugscheinwerfer wird dieser immer wieder Spritzwasser ausgesetzt, beispielsweise beim Reinigen des Kraftfahrzeugs. Das Verschlusselement nach der US 5 522 769 kann jedoch durch seinen Aufbau nicht gewährleisten, dass Wassertröpfchen die Filterscheibe benetzen. Neben der Gefahr, dass damit über die Filterscheibe Wasser auch in den Innenraum des Gehäuses eintreten kann, führt eine mit Wasser benetzte Filterscheibe dazu, dass diese luftundurchlässig und damit für einen Luftaustausch unbrauchbar wird.

Diesem Problem nimmt sich die EP 1 102 002 A2 an. In dieser Druckschrift wird ein Verschlusselement in Form einer luftdurchlässigen Kappe beschrieben. Diese Kappe weist einen zylindrischen Körper auf, der eine mittlere Durchgangsöffnung aufweist, die einseitig mit einer Filterscheibe verschlossen ist. An der Seite des zylindrischen Körpers sind Abstandselemente vorgesehen, die der Einstellung eines Abstandes zwischen dem zylindrischen Körper und einem auf diesen zylindrischen Körper aufsteckbaren zylindrischen Abdeckelement dient. Das zylindrische Abdeckelement hat ein geschlossenes Ende. Wird nun der zylindrischen Körper in das Abdeckelement eingesteckt, so stellt sich zwischen dem Körper und dem Abdeckelement sowie zwischen der Filterscheibe und dem verschlossenen Ende des Abdeckelementes ein Luftdurchlass ein. Die luftdurchlässige Kappe wird nunmehr mit dem zylindrischen Körper in die Belüftungsöffnung eingesteckt oder auf einen Dom der Belüftungsöffnung aufgesteckt. Dabei übernimmt der zylindrische Körper sogleich die Funktion einer Dichtung. Damit kann ein Luftaustausch über die mittlere Durchgangsöffnung, die Filterscheibe und den Luftdurchlass zwischen dem Innenraum des Gerätes und der Umgebungsluft stattfinden. Zur Realisierung dichtender Eigenschaften des Verschlusselementes sowohl für das Einstecken in die Gehäuseöffnung als auch für die Montage der einzelnen Bauteile besteht der zylindrische Körper aus einem Elastomer.

Obwohl bei diesem Verschlusselement der direkte Einfluss von Wasser auf die Filterscheibe vermieden werden kann, hat sich gezeigt, dass dennoch Wassertröpfchen über den Luftdurchlass auf die Filterscheibe gelangen können und damit die Filterscheibe unbrauchbar machen. Es hat sich weiterhin gezeigt, dass das Eindringen von Wasser durch die hydrophilen Eigenschaften des Elastomers besonders begünstigt wird. Darüber hinaus ist dieses bekannte Verschlusselement aus mehreren Teilen gefertigt und zusammengesetzt, wodurch sich ein hoher Fertigungsaufwand ergibt.

Ein weiteres Verschlusselement für Elektronikplatinen ist aus der JP 2005 150376 A umfassend eine Filterscheibe, ein Abdeckelement und eine Dichtung bekannt, bei dem die Filterscheibe von der Dichtung getrennt angeordnet ist und das Abdeckelement aus Polybutylenterephthalat besteht.

Der Erfindung liegt somit die Aufgabe zu Grunde, ein Verschlusselement für geschlossene Geräte zu schaffen, welches kostengünstig zu fertigen ist, den Eintritt von Flüssigkeit in das Gehäuse verhindert und mit geringem Aufwand sicher montierbar ist.

Die erfindungsgemäße Aufgabe wird durch ein Verschlusselement der eingangs genannten Art gelöst, bei dem das Abdeckelement aus einem hydrophoben Material besteht und die Filterscheibe von der Dichtung getrennt angeordnet und mit dem Abdeckelement verbunden ist, und das eine Öffnung aufweist. Die Öffnung ist durch eine Deckelseite einseitig verschlossen. Die zylindrische Öffnung bildet für das Abdeckelement eine Innenseite. Dabei bildet die Innenseite des Abdeckelementes zusammen mit dessen Außenseite einen Rand. An diesem Rand ist die Dichtung angeordnet. In einem Abstand zu der Deckelseite ist die Filterscheibe unter Bildung eines Ausgleichsraumes mit dem Rand umlaufend verbunden. In das Abdeckelement ist mindestens eine Ausgleichsöffnung eingebracht, die sich von dem Ausgleichsraum zur Außenseite hin erstreckt.

Durch die Öffnung kann einerseits ein Luftausgleich mit dem inneren Rahmen des geschlossenen Gerätes erfolgen. Andererseits ist die Öffnung durch die Filterscheibe geteilt in den Raum, der unmittelbar mit dem Innenraum des geschlossenen Gerätes in Verbindung steht, und in den Ausgleichsraum. Dieser Ausgleichsraum ist über die Ausgleichsöffnungen mit der äußeren Atmosphäre verbunden. Durch die Ausbildung eines Randes und die Anordnung der Dichtung an diesem Rand wird es möglich, das Verschlusselement in einfacher Weise durch eine selbsthemmende Verbindung an oder in dem Gehäuse zu fixieren. Damit wird eine einfache Montierbarkeit des Verschlusselementes gewährleistet.

Gemäß einer Ausführungsvariante besteht das Abdeckelement aus einem hydrophoben Material und die Filterscheibe ist von der Dichtung getrennt angeordnet und mit dem Abdeckelement verbunden.

Durch die hydrophobe Ausbildung des Abdeckelementes wird erreicht, dass sich Wasser nicht an dem Abdeckelement festsetzen kann und auch nicht von ihm geleitet wird. Wasser, welches auf das Abdeckelement gelangt, wird mithin von seiner Oberfläche abperlen. Bereits dadurch wird die Filterscheibe vor einem Wasserkontakt geschützt. Da außerdem die Filterscheibe mit dem Abdeckelement und nicht mit der Dichtung verbunden ist, wie dies nach dem Stand der Technik der Fall wäre, wird wiederum durch die hydrophoben Eigenschaften des Abdeckelementes vermieden, dass Wasser an seiner Oberfläche entlang geleitet wird und somit auf die Filterscheibe gelangt. Da das Elastomer der Dichtung hydrophile Eigenschaften aufweist, wird durch die Trennung von Dichtung und Filterscheibe außerdem erreicht, dass Wasser nicht über die hydrophile Dichtung zu der Filterscheibe gelangen kann.

Wasser könnte höchstens durch die Ausgleichsöffnungen in den Ausgleichsraum und somit auch auf die Filterscheibe gelangen. Da diese Ausgleichsöffnungen jedoch in das Abdeckelement eingebracht sind, welches einerseits aus einem hydrophoben Material besteht, wird verhindert, dass Wasser in diesen Ausgleichsraum gelangt. Andererseits ist die aus einem hydrophilen Material bestehende Dichtung lediglich mit dem Rand des hydrophoben Abdeckelementes verbunden. Durch diese Maßnahme wird verhindert, dass über die Dichtung Wasser zu der Filterscheibe gelangt. Eine Leitung von Wasser, welches sich an der Dichtung festsetzen kann, zu der Filterscheibe wird nämlich durch die dazwischen liegende Oberfläche des hydrophoben Abdeckelementes verhindert.

In einer günstigen Ausführungsform der Erfindung ist vorgesehen, dass das Abdeckelement derart zylindrisch ausgebildet ist, dass die Öffnung einen kreisrunden Querschnitt aufweist. Die Fertigung des Abdeckelementes als zylindrisches Element ist mit einem nur geringen Fertigungsaufwand verbunden.

In einer weiteren Ausgestaltung der Erfindung ist vorgesehen, dass die Öffnung mit einer Schulter versehen ist, die eine ringförmige Ansatzfläche parallel zur Deckelseite bildet. Diese Ausgestaltung stellt eine besonders günstige Möglichkeit zur Befestigung der Filterscheibe in dem Abdeckelement dar. Auf diese Ansatzfläche kann nämlich die Filterscheibe in einfacher Weise, beispielsweise durch Kleben, befestigt werden.

In einer günstigen Ausgestaltung der Erfindung ist vorgesehen, dass die Dichtung einen Kraftschluss zwischen der Innenseite und einem Lüftungsdom an dem Gerät, auf den das Verschlusselement aufsteckbar ist, oder einen Kraftschluss zwischen der Außenseite und einer Lüftungsöffnung an dem Gerät, in die das Verschlusselement einsteckbar ist, erzeugend angeordnet ist. Der Kraftschluss wird dabei dadurch erzeugt, dass zwischen dem Abdeckelement beziehungsweise dem Rand des Abdeckelementes und dem in Gerät ein Abstand eingestellt ist, der etwas geringer ist, als die Stärke der Dichtung. Damit kann die Dichtung in diesen Abstand hinein gedrückt werden, wobei unter Ausnutzung der Elastizität der Dichtung eine Presskraft entsteht, die einerseits den Kraftschluss und andererseits die Dichtungsfunktion bewirkt.

Eine Möglichkeit der Anordnung der Dichtung besteht darin, dass die Dichtung an der Innenseite angeordnet ist. Insbesondere dadurch wird es ermöglicht, dass die Dichtung einen Kraftschluss zwischen der Innenseite und einem Lüftungsdom an dem Gerät, auf den das Verschlusselement aufsteckbar ist, erzeugend angeordnet ist.

Eine andere Möglichkeit der Anordnung der Dichtung besteht darin, dass die Dichtung an der Außenseite angeordnet ist. Insbesondere dadurch wird es möglich, dass die Dichtung einen Kraftschluss zwischen der Außenseite und einer Lüftungsöffnung in dem Gerät, in die das Verschlusselement einsteckbar ist, erzeugend angeordnet ist.

Zusätzlich zu der selbsthemmenden Montage des Abdeckelementes mittels der kraftschlüssig steckbaren Dichtung kann es zweckmäßig sein, eine weitere Fixierungsmöglichkeit vorzusehen, unter anderem deshalb, um eine in ihrer Festigkeit sichere Montage zu gewährleisten. Dazu ist es zweckmäßig, dass an dem Rand Rastelemente angeordnet sind, die mit dem Gehäuse derart korrespondieren, dass das Verschlusselement an dem Gehäuse fixierbar ist.

Derartige Rastelemente können an der Außenseite angeordnet sein und mit einer dem Verschlusselement abgewandten Kante einer Lüftungsöffnung in dem Gerät, mit einem Hinterschnitt oder einer Rastnut in der Öffnung korrespondieren.

Es besteht aber auch die Möglichkeit, dass die Rastelemente an der Innenseite angeordnet sind und mit einer Rastwulst oder einer Rastnut an einem Lüftungsdom korrespondieren.

In beiden Fällen wird es möglich, das Abdeckelement in eine Lüftungsöffnung einzudrücken, wodurch einerseits der Kraftschluss des Dichtungselementes entsteht und andererseits die Rastenasen verhindern, dass das Abdeckelement entgegen dem Kraftschluss heraus- oder abrutscht.

In einer Ausgestaltung ist hierzu vorgesehen, dass Laschen, die sich über den Rand in von der Deckelseite abgewandter Richtung über den Rand hinaus erstrecken, mit der Innenseite verbunden und mit Rastnasen versehen sind. Insbesondere kann der Rand an seiner Unterseite, das heißt zwischen der Innenseite und der Außenseite, mit einem elastischen Element versehen werden.

Um einen straffen Sitz der Rastenasen- oder Clip-Verbindung zu gewährleisten, ist es in zweckmäßig, dass der Rand an seiner Unterseite, das heißt zwischen der Innenseite und der Außenseite, mit einem elastischen Element versehen ist. Wenn sich der Rand in der Lüftungsöffnung oder auf dem Lüftungsdom des Gerätes abstützt, dann wird die Elastizität des elastischen Elementes zum Tragen kommen, indem beim Einsetzen des Abdeckelementes das elastische Element zusammengedrückt wird, bis die Rastelemente in die korrespondierenden Elemente einrasten und dass auf die Rastverbindung infolge der Elastizität eine Gegenkraft ausüben, die die Rastung sicher und spielfrei hält.

In einer weiteren Ausgestaltung der Erfindung ist vorgesehen, dass die Dichtung den Rand von der Innenseite bis zur Außenseite des Abdeckelementes übergibt. Somit wird es möglich, dass das erfindungsgemäße Verschlusselement sowohl in eine einfache Öffnung in der Wandung des Gerätes eingesetzt wird, wobei hierbei der Teil der Dichtung, der sich an der Außenseite des Abdeckelementes befindet, die Dichtfunktion übernimmt. Damit kann das Verschlusselement aber auch auf einen Dom auf der Wandung des Gerätes ausgesetzt werden, wenn die Öffnung in der Wandung des Gerätes mit einem solchen Dom versehen ist. In diesem Falle würde die Dichtfunktion von dem Teil der Dichtung, der sich an der Innenseite des Abdeckelementes befindet, übernommen werden. In einer weiteren Ausgestaltung des erfindungsgemäßen Verschlusselementes ist vorgesehen, dass mindestens zwei Ausgleichsöffnungen angeordnet sind, die sich parallel zur Deckelseite erstrecken. Dadurch wird einerseits eine gewisse Redundanz erreicht, wodurch auch dann noch ein Luftaustausch stattfinden kann, wenn eine Ausgleichsöffnung ungewollt verschlossen ist. Durch die parallele Anordnung der Ausgleichsöffnungen in Bezug auf die Deckelseite, zu der auch die Filterscheibe parallel liegt, wird eine weitere Erschwernis des Eintritts von Wasser erreicht. Sollte darüber hinaus dennoch Wasser durch die Ausgleichsöffnungen gelangen, so wird dieses höchstens den Rand der Filterscheibe benetzen und somit keinen nennenswerten Schaden hervorrufen.

In einer weiteren Ausgestaltung der Erfindung ist vorgesehen, dass der Ausgleichsraum durch einen senkrecht zur Deckelseite liegenden ersten Steg geteilt ist. Dieser Steg ist an der Deckelseite angeordnet und steht senkrecht auf ihr. Er erstreckt sich von der Deckelseite bis zur Filterscheibe. Damit wird es im Übrigen auch möglich, dass die Filterscheibe zusätzlich an diesen Steg befestigt ist. Jeder Teil des Ausgleichsraumes ist mit einer eigenen Ausgleichsöffnung versehen. Durch diese Teilung wird erreicht, dass in jedem Falle ein Teil des Ausgleichsraumes mit seinem dazugehörigen Teil der Filterscheibe noch in Wirkung bleibt, sollte der andere Teil doch durch eingedrungenes Wasser unwirksam geworden sein.

Eine noch größere Redundanz wird diesbezüglich erreicht, wenn der Ausgleichsraum mindestens durch zwei Stege, die sich senkrecht zur Deckelseite von der Deckelseite bis zu der Filterscheibe erstrecken, in mehrere Teilräume geteilt ist und jeder Teilraum mit einer Ausgleichsöffnung versehen ist. Damit können drei und mehr Teilräume geschaffen werden, wobei der Anteil eines möglicherweise unwirksamen Teilraumes an der gesamten Durchlassfläche geringer wird, als bei einer zweifachen Teilung.

Besonders zweckmäßig ist es, wenn auch das Material der Filterscheibe hydrophob ausgebildet ist. Einerseits wird dadurch verhindert, dass die Filterscheibe ohnehin Wasser annimmt. Andererseits wird eingedrungenes Wasser auf der Filterscheibe perlen und leicht wieder durch in die Ausgleichsöffnungen austreten können. Neben der Möglichkeit, die hydrophoben Eigenschaften auf chemischem Wege, beispielsweise durch Zusatz bestimmter Substanzen zu dem Material der Fensterscheibe herzustellen, besteht eine weitere Möglichkeit darin, dass die Filterscheibe mit einer hydrophob wirkenden Oberflächenstruktur, beispielsweise mit einer die einen als Lotus-Effekt bekannten Effekt bewirkt, versehen wird.

Aber auch eine der Filterscheibe gegenüberliegende Innenseite des Abdeckelementes weist eine hydrophob wirkende Oberflächenstruktur auf. Obwohl das Abdeckelement ohnehin aus einem hydrophoben Material besteht, kann dadurch der hydrophobe Effekt noch verstärkt werden. Auch hier besteht eine günstige Möglichkeit darin, die Oberflächenstruktur so zu gestalten, dass ein als Lotus-Effekt bekannter Effekt bewirkt wird.

Selbstverständlich ist es möglich, sowohl die Filterscheibe als auch die Innenseite der Deckelseite mit einer hydrophoben Oberflächenstruktur zu versehen.

Unterstützt wird dies in einer weiteren Ausgestaltung der Erfindung dadurch, dass zwischen der Filterscheibe und der Deckelseite der Abstand, der zugleich die Höhe des Ausgleichsraumes darstellt, größer gewählt ist, als der Durchmesser eines sich in diesem Raum bildenden Wassertropfens. Obwohl der Wassertropfen in diesem Falle ohnehin von hydrophobem Material umgeben wäre und somit ohnehin perlen würde, wird durch diese großräumige Ausbildung bewirkt, dass ein Wassertropfen an einem Herausgleiten aus dem Ausgleichsraum behindert wird.

In einer anderen Ausgestaltung ist vorgesehen, dass sich der Abstand zwischen der Filterscheibe und der Deckelseite, das heißt die Höhe des Ausgleichsraumes in radialer Richtung zum Zentrum des Ausgleichsraumes hin verringert. Dies kann zweckmäßigerweise dadurch erreicht werden, dass die Filterscheibe oder die Innenseite der Deckelseite einzeln oder beide jeweils in Richtung zu der anderen Seite hin gewölbt oder kegelförmig ausgebildet sind. Durch die Wahl dieser Geometrie des Ausgleichsraumes wird erreicht, dass ein eingedrungener Wassertropfen aufgrund seines Bestrebens stets eine Deformation seiner Kugelform zu vermeiden, wieder aus dem Ausgleichsraum herausgetrieben wird.

Die Erfindung soll nachfolgend anhand eines Ausführungsbeispieles näher erläutert werden. In den zugehörigen Zeichnungen zeigt
- Fig. 1: einen Querschnitt durch ein erfindungsgemäßes Verschlusselement,
- Fig. 2: einen Querschnitt entlang der Linie II-II in Fig. 1,
- Fig. 3: einen Querschnitt durch ein erfindungsgemäßes Verschlusselement mit einer einfachen Teilung des Ausgleichsraumes,
- Fig. 4: einen Querschnitt durch ein erfindungsgemäßes Verschlusselement mit einer vierfachen Teilung des Ausgleichsraumes,
- Fig. 5: einen Querschnitt durch ein erfindungsgemäßes Verschlusselement in einer Einbaulage auf einem Dom eines Gehäuses eines Gerätes,
- Fig. 6: einen Querschnitt durch ein erfindungsgemäßes Verschlusselement in einer Einbaulage in einer Öffnung in einem Gehäuse eines Gerätes,
- Fig. 7: einen Querschnitt durch ein erfindungsgemäßes Verschlusselement mit einem sich radial verjüngenden Ausgleichsraum
- Fig. 8: eine perspektivische Darstellung eines weiteren Ausführungsbeispieles eines erfindungsgemäßen Verschlusselementes mit Rastnasen und
- Fig. 9: eine Schnittdarstellung einer Lüftungsöffnung eines Gerätes mit einem eingesetzten Verschlusselement dieser Ausführungsform.

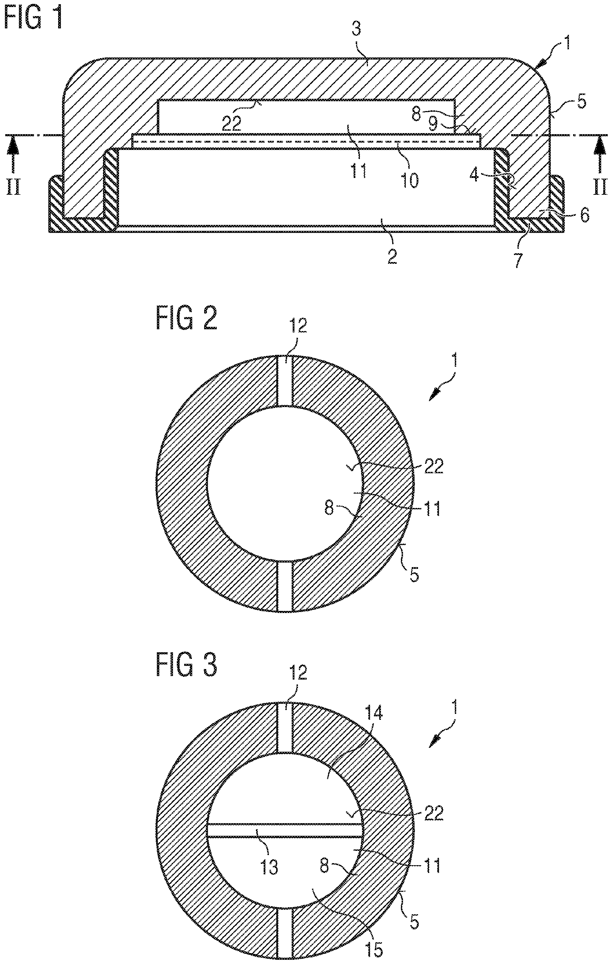

Wie in Fig. 1 dargestellt, besteht das erfindungsgemäße Abdeckelement 1 aus einem zylindrischen Spritzgussteil als hydrophobem Material. Es weist eine Öffnung 2 auf, die durch eine Deckelseite 3 einseitig verschlossen ist. Die zylindrische Öffnung 2 bildet eine Innenseite 4 des Abdeckelementes 1. Die Innenseite 4 bildet mit der Außenseite 5 des Abdeckelementes 1 einen Rand 6. Mit dem Rand 6 ist eine Dichtung 7 verbunden. Dabei umgreift die Dichtung 7 den Rand 6 an seiner Unterseite, indem sich diese von der Innenseite 4 bis zur Außenseite 5 des Abdeckelementes 1 erstreckt.

Die zylindrische Öffnung 2 ist mit einer Schulter 8 versehen, die eine ringförmige Ansatzfläche 9 bildet, die parallel zur Deckelseite 3 liegt. An dieser Ansatzfläche 9 ist eine Filterscheibe 10 befestigt, beispielsweise aufgeklebt. Dadurch wird die Filterscheibe 10 in einem Abstand zu der Deckelseite 3 angeordnet, wodurch ein Ausgleichsraum 11 gebildet wird.

Wie in Fig. 2 dargestellt, sind in dem Abdeckelement 1 zwei Ausgleichsöffnungen 12 eingebracht, die sich von dem Ausgleichsraum 11 bis zur Außenseite 5 des Abdeckelementes 1 erstrecken, also das Abdeckelement 1 durchdringen.

Wie in Fig. 3 dargestellt, besteht eine Möglichkeit der Umhüllung der Funktionssicherheit des erfindungsgemäßen Abdeckelementes 1 darin, dass ein erster Steg 13 vorgesehen ist, der sich von der Deckelseite 3 bis zu der Filterscheibe 10 erstreckt. Dadurch wird der Ausgleichsraum 11 in einen ersten Teil 14 und einem zweiten Teil 15 geteilt. Dabei erfolgt die Teilung derart, dass jeder der beiden Teile 14, 15 mit einer der Ausgleichsöffnungen 12 versehen ist.

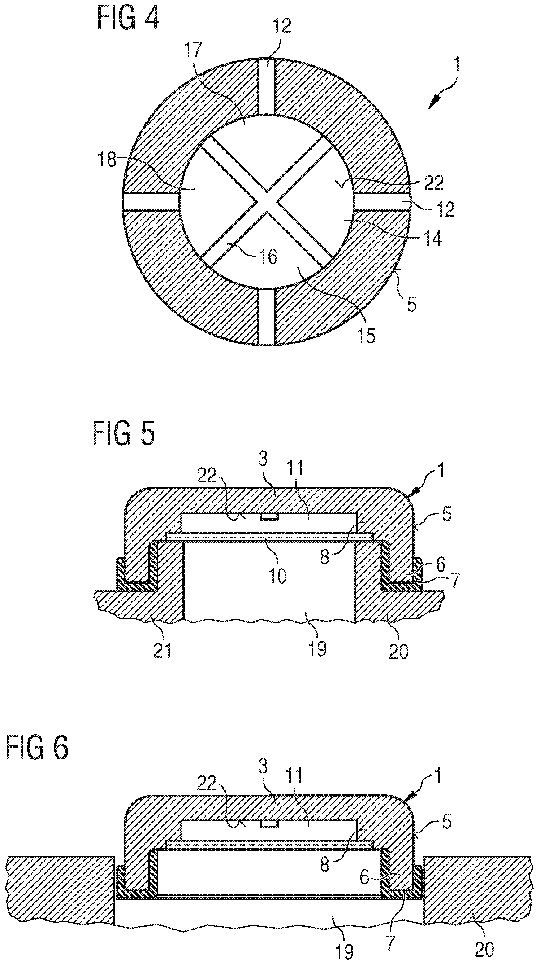

Wie in Fig. 4 dargestellt, besteht auch die Möglichkeit, die Redundanz der Teile des Ausgleichsraumes 11 zu erhöhen, indem ein zweiter Steg 16 vorgesehen wird, durch den der Ausgleichsraum 11 in vier Teile 14, 15, 17 und 18 geteilt wird. Jeder dieser Teile 14, 15, 17 und 18 ist dann mit einer der Ausgleichsöffnungen 12 versehen.

Wie in Fig. 5 dargestellt, ist eine Öffnung 19 in der Wandung 20 eines Gehäuses mit einem Dom 21 versehen. Infolge der Anordnung in der Dichtung 7 auf der Innenseite 4 des Abdeckelementes 1 kann das Abdeckelement 1 auf den Dom 21 aufgesteckt werden.

Umgekehrt ist es möglich, dass das Abdeckelement 1 in die Öffnung 19 der Wandung 20 eingesteckt wird, wobei die Dichtfunktion der Dichtung 7 mit ihrem Teil, der sich an der Außenseite 5 befindet, genutzt wird, wie dies in Fig. 6 dargestellt ist.

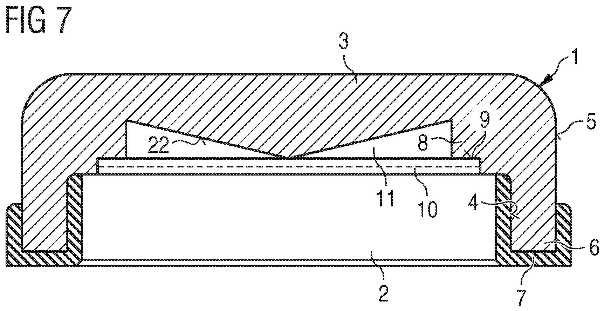

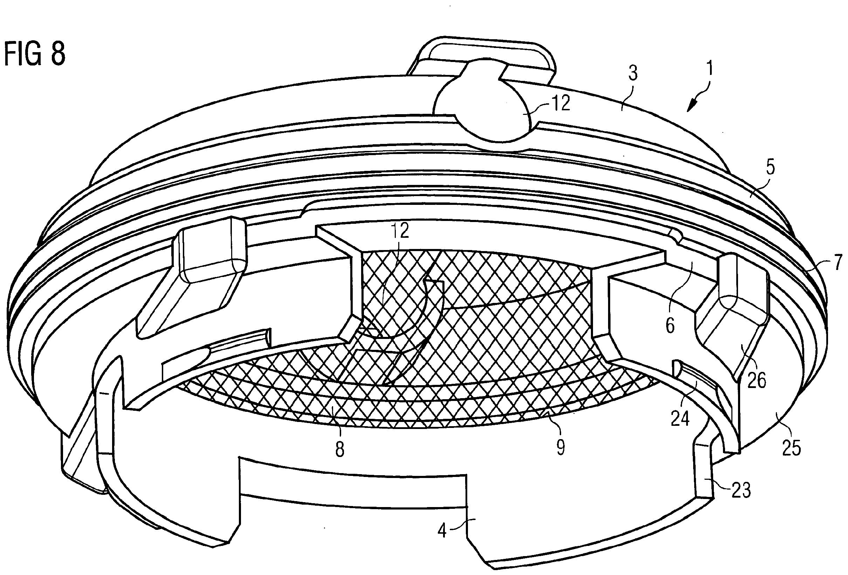

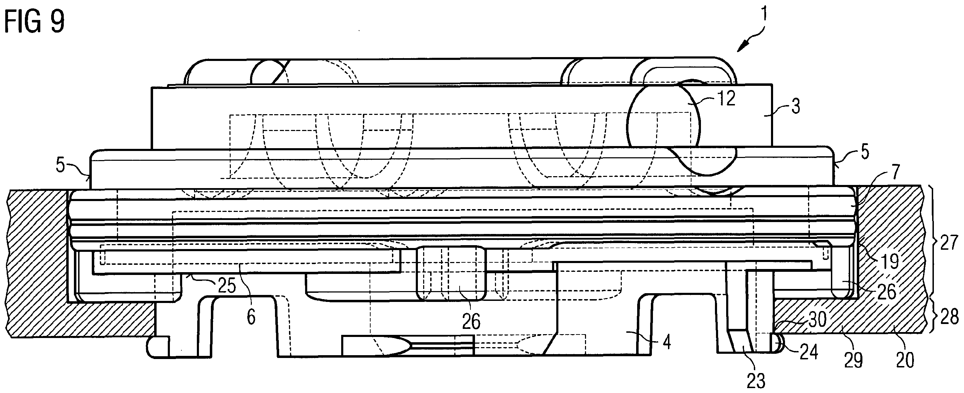

Fig. 7 zeigt eine Ausgestaltung des Abdeckelementes 1, bei dem die Innenseite 22 der Deckelseite 3 derart kegelförmig ausgebildet ist, dass sich der Abstand zwischen der Deckelseite 3 und der Filterscheibe 10 zur Mitte hin verringert. Da ein Wassertropfen stets das Bestreben hat, eine Kugelform einzunehmen, würde eine Bewegung des Wassertropfens zum Zentrum hin eine zusätzliche Deformation bedeuten. Dieser Deformation weicht der Tropfen aus und er wird somit an den Rand gedrängt, wo sich die Ausgleichsöffnungen 12 befinden. Durch diese kann er dann wieder nach außen treten. Zur Unterstützung dieses Effekts kann die Innenseite 22 im Bereich der Ausgleichsöffnungen noch zusätzliche Wölbungen (nicht näher dargestellt) aufweisen, die diesen Effekt des Herausdrängens unterstützen oder dem Tropfen ein Herausrollen erleichtern. Wie in Fig. 8 und Fig. 9 dargestellt, weist auch dieses Verschlusselement ein Abdeckelement 1 auf, dessen Deckelseite 3 mit einer Ausgleichsöffnung 12 versehen ist. Auch hier weist die Öffnung 2 eine Schulter 8 auf, die eine ringförmige Ansatzfläche 9 parallel zu der Deckelseite 3 bildet. Mit dieser Ansatzfläche 9 ist die Filterscheibe 10, die in Fig. 8 kreuzschraffiert dargestellt ist, um die Strukturen dahinter deutlich werden zu lassen, verbunden.

Der Rand 6 wird gebildet zwischen der Außenseite 5 und der Innenseite 4. Über diesen Rand 6 hinaus erstrecken sich in von der Deckelseite 3 abgewandter Richtung Laschen 23, die mit der Innenseite 4 verbunden sind. Die Laschen 23 sind mit Rastnasen 24 versehen. An der Unterseite 25 des Randes 6, die von der Außenseite 5 und der Innenseite 4 eingeschlossen wird, sind elastische Elemente 26 angeordnet.

An der Außenseite 5 ist das Abdeckelement 1 mit einer Dichtung 7 versehen.

Wie in Fig. 9 dargestellt, wird das Gerät mit dem Verschlusselement derart versehen, dass in eine Lüftungsöffnung 19 in der Wandung 20 des Gerätes das Abdeckelement 1 eingedrückt wird. Dabei ist der Außendurchmesser der an der Außenseite 5 angeordneten Dichtung 7 geringfügig größer als der Innendurchmesser der Öffnung 19 in ihrem oberen Bereich 27. Mithin wird beim Eindrücken des Abdeckelementes 1 in die Öffnung 19 die Dichtung 7 elastisch verformt und stellt damit zwischen dem Abdeckelement 1 und der Wandung 20 des Gerätes einen Kraftschluss her, der bereits für einen sicheren Sitz des Abdeckelementes 1 sorgt.

Zur Erhöhung der Sicherheit der Montag wird noch eine Clip-Verbindung vorgesehen. Hierzu ist im unteren Bereich 28 der Öffnung 19 ein Ansatz 29 vorgesehen, auf den sich einerseits die Unterseite 25 des Randes 6 mit ihren elastischen Elementen abstützt. Außerdem weist der Ansatz 29 eine Kante 30 auf, hinter die die Rastnasen 24 greifen und für eine Clip-Verbindung sorgen.

Dabei ist der Abstand der Unterseite 25 von der Kante 30 so gewählt, dass ein Einrasten der Rastnasen 24 an der Kante nur unter elastischer Verformung der elastischen Elemente 26 erfolgen kann, wodurch ein spielfreier Sitz gewährleistet werden kann.

Grundsätzlich wäre natürlich auch möglich, auf den Ansatz 29 zu verzichten und die Rastnasen 24 direkt an der Außenseite 5 anzuordnen. Dann würden die Rastnasen unter die Kante der Öffnung 19 greifen. Dabei könnte entweder auf die elastischen Elemente 26 verzichtet werden, was unter anderem dadurch vertretbar wäre, dass ja der Kraftschluss der Dichtung 7 bereits für einen spielfreien Sitz sorgt. Es wäre jedoch auch möglich, beispielsweise die Deckelseite über die Außenseite 5 hinaus zu erstrecken, wodurch sich ein oberer Absatz oder Rand bilden würde, an dessen zur Wandung weisenden Ende dann ebenfalls elastische Elemente angeordnete werden könnten.

### Bezugszeichenliste

- 1: Abdeckelement
- 2: Öffnung
- 3: Deckelseite
- 4: Innenseite
- 5: Außenseite
- 6: Rand
- 7: Dichtung
- 8: Schulter
- 9: Ansatzfläche
- 10: Filterscheibe
- 11: Ausgleichsraum
- 12: Ausgleichsöffnung
- 13: erster Steg
- 14: erster Teil
- 15: zweiter Teil
- 16: zweiter Steg
- 17: Teil der Ausgleichsöffnung
- 18: Teil der Ausgleichsöffnung
- 19: Öffnung in der Wandung
- 20: Wandung
- 21: Dom
- 22: Innenseite der Deckelseite
- 23: Lasche
- 24: Rastnase
- 25: Unterseite
- 26: elastisches Element
- 27: oberer Bereich der Öffnung
- 28: unterer Bereich der Öffnung
- 29: Ansatz
- 30: Kante

## Patentansprüche

1. Luftdurchlässiges Verschlusselement für geschlossene Geräte mit einer Filterscheibe (10), einem die Filterscheibe (10) überdeckenden Abdeckelement (1) und einer aus einem Elastomer bestehenden Dichtung (7), wobei das Abdeckelement (1) eine Öffnung (2) aufweist, die durch eine Deckelseite (3) einseitig verschlossen ist und die eine Innenseite (4) des Abdeckelementes (1) bildet, wobei das Abdeckelement (1) aus einem hydrophoben Material besteht und die Filterscheibe (10) von der Dichtung (7) getrennt angeordnet ist, dass die Innenseite (4) des Abdeckelementes (1) zusammen mit dessen Außenseite (5) einen Rand (6) bildet, dass die Filterscheibe (10) in einem Abstand zu der Deckelseite (3) unter Bildung eines Ausgleichsraumes (11) mit dem Rand (6) umlaufend verbunden ist, **dadurch gekennzeichnet, dass** die Filterscheibe (10) mit dem Abdeckelement (1) verbunden ist, dass in das Abdeckelement (1) eine Ausgleichsöffnung (12) eingebracht ist, die sich vom dem Ausgleichsraum (11) zur Außenseite (5) erstreckt und dass die Dichtung (7) an dem Rand (6) angeordnet ist.

2. Luftdurchlässiges Verschlusselement nach Anspruch 1, **dadurch gekennzeichnet, dass** das Abdeckelement (1) aus einem hydrophoben Material besteht und die Filterscheibe (10) von der Dichtung (7) getrennt angeordnet und mit dem Abdeckelement (1) verbunden ist.

3. Luftdurchlässiges Verschlusselement nach Anspruch 1 oder 2, **dadurch gekennzeichnet, dass** das Abdeckelement (1) derart zylindrisch ausgebildet ist, dass die Öffnung (2) einen kreisrunden Querschnitt aufweist und dass die Öffnung (2) mit einer Schulter (8) versehen ist, die eine ringförmige Ansatzfläche (9) parallel zur Deckelseite (3) bildet und dass die Filterscheibe (10) auf dieser Ansatzfläche (9) mit dem Abdeckelement (1) verbunden ist.

4. Luftdurchlässiges Verschlusselement nach einem der vorstehenden Ansprüche, **dadurch gekennzeichnet, dass** die Dichtung (7) den Rand (6) von der Innenseite (4) bis zur Außenseite (5) des Abdeckelementes (1) umgibt und dass die Dichtung (7) einen Kraftschluss zwischen der Innenseite (4) und einem Lüftungsdom (21) an dem Gerät, auf den das Verschlusselement aufsteckbar ist, oder einen Kraftschluss zwischen der Außenseite (5) und einer Lüftungsöffnung (19) an dem Gerät, in die das Verschlusselement einsteckbar ist, erzeugend angeordnet ist.

5. Luftdurchlässiges Verschlusselement nach einem der Ansprüche 1 bis 3, **dadurch gekennzeichnet, dass** die Dichtung (7) an der Innenseite (4) angeordnet ist und dass die Dichtung (7) einen Kraftschluss zwischen der Innenseite (4) und einem Lüftungsdom (21) an dem Gerät, auf den das Verschlusselement aufsteckbar ist, erzeugend angeordnet ist.

6. Luftdurchlässiges Verschlusselement nach einem der Ansprüche 1 bis 3, **dadurch gekennzeichnet, dass** die Dichtung (7) an der Außenseite (5) angeordnet ist und dass die Dichtung (7) einen Kraftschluss zwischen der Außenseite (5) und einer Lüftungsöffnung (19) in dem Gerät, in die das Verschlusselement einsteckbar ist, erzeugend angeordnet ist.

7. Luftdurchlässiges Verschlusselement nach einem der vorstehenden Ansprüche, **dadurch gekennzeichnet, dass** an dem Rand Rastelemente (24) angeordnet sind, die mit dem Gerät derart korrespondieren, dass das Verschlusselement an dem Gerät fixierbar ist, derart, dass die Rastelemente (24) an der Außenseite (5) angeordnet sind und mit einer dem Verschlusselement abgewandten Kante (30) einer Lüftungsöffnung (19) in dem Gerät, mit einem Hinterschnitt oder einer Rastnut in der Öffnung korrespondieren oder dass die Rastelemente (24) an der Innenseite (4) angeordnet sind und mit einer Rastwulst oder einer Rastnut an einem Lüftungsdom (21) korrespondieren.

8. Luftdurchlässiges Verschlusselement nach Anspruch 7, **dadurch gekennzeichnet, dass** der Rand (6) an seiner Unterseite (25), das heißt zwischen der Innenseite (4) und der Außenseite (5), mit einem elastischen Element (26) versehen ist.

9. Luftdurchlässiges Verschlusselement nach einem der vorstehenden Ansprüche, **dadurch gekennzeichnet, dass** der Ausgleichsraum (11) durch einen senkrecht zur Deckelseite (3) liegenden ersten Steg (13), der sich von der Deckelseite (3) bis zu der Filterscheibe (10) erstreckt, geteilt ist und jeder Teil des Ausgleichsraumes (11) mit einer Ausgleichsöffnung (12) versehen ist.

10. Luftdurchlässiges Verschlusselement nach einem der vorstehenden Ansprüche, **dadurch gekennzeichnet, dass** das Material der Filterscheibe (10) hydrophob ausgebildet ist.

11. Luftdurchlässiges Verschlusselement nach einem der vorstehenden Ansprüche, **dadurch gekennzeichnet, dass** eine der Filterscheibe (10) gegenüberliegende Innenseite (22) des Abdeckelementes (1) eine hydrophob wirkende Oberflächenstruktur aufweist.

12. Luftdurchlässiges Verschlusselement nach einem der vorstehenden Ansprüche, **dadurch gekennzeichnet, dass** der Abstand zwischen der Filterscheibe (10) und der Deckelseite (3), das heißt die Höhe des Ausgleichsraumes (11) größer gewählt ist als der Durchmesser eines sich in diesem Raum (11) bildenden Wassertropfens.

13. Luftdurchlässiges Verschlusselement nach einem der vorstehenden Ansprüche, **dadurch gekennzeichnet, dass** sich der Abstand zwischen der Filterscheibe (10) und der Deckelseite (3), das heißt die Höhe des Ausgleichsraumes (11) in radialer Richtung zum Zentrum des Ausgleichsraumes hin verringert.

14. Luftdurchlässiges Verschlusselement nach Anspruch 13, **dadurch gekennzeichnet, dass** die Innenseite (22) der Deckelseite (3) in Richtung zu der Filterscheibe (10) hin gewölbt oder kegelförmig ausgebildet ist.

15. Luftdurchlässiges Verschlusselement nach einem der Ansprüche 1 bis 12, **dadurch gekennzeichnet, dass** das Abdeckelement (1) zusammen mit der Dichtung (7) als Zwei-Komponenten-Spritzgussteil ausgebildet ist.

## Claims

1. Air-permeable closure element for closed units comprising a filter disk (10), a covering element (1) covering the filter disk (10) and a seal (7) composed of an elastomer, wherein the covering element (1) has an opening (2) which is closed on one side by a cover side (3) and which forms an inner face (4) of the covering element (1), wherein the covering element (1) consists of a hydrophobic material and the filter disk (10) is arranged separately from the seal (7), in that the inner face (4) of the covering element (1) together with the outer face (5) thereof forms an edge (6), in that the filter disk (10) is connected peripherally to the edge (6) at a distance from the cover side (3), forming a compensating space (11), **characterized in that** the filter disk (10) is connected to the covering element (1), **in that** in the covering element (1) a compensating opening (12) is incorporated, which extends from the compensating space (11) toward the outer face (5) and **in that** the seal (7) is arranged on the edge (6).

2. Air-permeable closure element according to Claim 1, **characterized in that** the covering element (1) consists of a hydrophobic material and the filter disk (10) is arranged separately from the seal (7) and is connected to the covering element (1).

3. Air-permeable closure element according to Claim 1 or 2, **characterized in that** the covering element (1) is of cylindrical configuration, such that the opening (2) has a circular cross section and **in that** the opening (2) is provided with a shoulder (8) which forms an annular attachment surface (9) parallel to the cover side (3) and **in that** the filter disk (10) is connected on this attachment surface (9) to the covering element (1) .

4. Air-permeable closure element according to one of the preceding claims, **characterized in that** the seal (7) surrounds the edge (6) from the inner face (4) to the outer face (5) of the covering element (1) and **in that** the seal (7) is arranged to produce a non-positive connection between the inner face (4) and a ventilation dome (21) on the unit, onto which the closure element may be positioned, or a non-positive connection between the outer face (5) and a ventilation opening (19) on the unit, into which the closure element may be inserted.

5. Air-permeable closure element according to one of Claims 1 to 3, **characterized in that** the seal (7) is arranged on the inner face (4) and **in that** the seal (7) is arranged to produce a non-positive connection between the inner face (4) and a ventilation dome (21) on the unit, onto which the closure element may be positioned.

6. Air-permeable closure element according to one of Claims 1 to 3, **characterized in that** the seal (7) is arranged on the outer face (5) and **in that** the seal (7) is arranged to produce a non-positive connection between the outer face (5) and a ventilation opening (19) in the unit, into which the closure element may be inserted.

7. Air-permeable closure element according to one of the preceding claims, **characterized in that** latching elements (24) are arranged on the edge which correspond with the unit such that the closure element may be fixed to the unit, such that the latching elements (24) are arranged on the outer face (5) and, with an edge (30) of a ventilation opening (19) in the unit remote from the closure element, correspond with an undercut or a latching groove in the opening or that the latching elements (24) are arranged on the inner face (4) and correspond with a latching bead or a latching groove on a ventilation dome (21).

8. Air-permeable closure element according to Claim 7, **characterized in that** the edge (6) at its underside (25) i.e. between the inner face (4) and the outer face (5), is provided with a resilient element (26).

9. Air-permeable closure element according to one of the preceding claims, **characterized in that** the compensating space (11) is divided by a first web (13) located perpendicular to the cover side (3) which extends from the cover side (3) to the filter disk (10), and each part of the compensating space (11) is provided with a compensating opening (12).

10. Air-permeable closure element according to one of the preceding claims, **characterized in that** the material of the filter disk (10) is configured to be hydrophobic.

11. Air-permeable closure element according to one of the preceding claims, **characterized in that** an inner face (22) of the covering element (1) opposing the filter disk (10) has a surface structure acting in a hydrophobic manner.

12. Air-permeable closure element according to one of the preceding claims, **characterized in that** the spacing between the filter disk (10) and the cover side (3) i.e. the height of the compensating space (11), is selected to be larger than the diameter of a drop of water formed in this space (11).

13. Air-permeable closure element according to one of the preceding claims, **characterized in that** the spacing between the filter disk (10) and the cover side (3) i.e. the height of the compensating space (11), is reduced in the radial direction toward the center of the compensating space.

14. Air-permeable closure element according to Claim 13, **characterized in that** the inner face (22) of the cover side (3) is configured in the direction of the filter disk (10) to be convex or conical.

15. Air-permeable closure element according to one of Claims 1 to 12, **characterized in that** the covering element (1) is configured together with the seal (7) as a two-component injection-molded part.

## Revendications

1. Élément de fermeture perméable à l'air pour appareils fermés comprenant un disque filtrant (10), un élément de recouvrement (1) recouvrant le disque filtrant (10) et un joint d'étanchéité (7) constitué d'un élastomère, l'élément de recouvrement (1) présentant une ouverture (2) qui est fermée d'un côté par un côté de couvercle (3) et qui forme un côté intérieur (4) de l'élément de recouvrement (1), l'élément de recouvrement (1) se composant d'un matériau hydrophobe et le disque filtrant (10) étant disposé de manière séparée du joint d'étanchéité (7), que le côté intérieur (4) de l'élément de recouvrement (1) conjointement avec son côté extérieur (5) forme un bord (6), que le disque filtrant (10) est connecté au bord (6) sur la périphérie à distance du côté de couvercle (3) en formant un espace de compensation (11), **caractérisé en ce que**
le disque filtrant (10) est connecté à l'élément de recouvrement (1), **en ce qu'**une ouverture de compensation (12) est réalisée dans l'élément de recouvrement (1), laquelle s'étend depuis l'espace de compensation (11) vers le côté extérieur (5) et **en ce que** le joint d'étanchéité (7) est disposé au niveau du bord (6).

2. Élément de fermeture perméable à l'air selon la revendication 1, **caractérisé en ce que** l'élément de recouvrement (1) se compose d'un matériau hydrophobe et le disque filtrant (10) est disposé de manière séparée du joint d'étanchéité (7) et est connecté à l'élément de recouvrement (1).

3. Élément de fermeture perméable à l'air selon la revendication 1 ou 2, **caractérisé en ce que** l'élément de recouvrement (1) est réalisé sous forme cylindrique de telle sorte que l'ouverture (2) présente une section transversale ronde circulaire et que l'ouverture (2) est pourvue d'un épaulement (8) qui forme une surface de base (9) de forme annulaire parallèlement au côté du couvercle (3) et **en ce que** le disque filtrant (10) est connecté sur cette surface de base (9) à l'élément de recouvrement (1).

4. Élément de fermeture perméable à l'air selon l'une quelconque des revendications précédentes, **caractérisé en ce que** le joint d'étanchéité (7) entoure le bord (6) depuis le côté intérieur (4) jusqu'au côté extérieur (5) de l'élément de recouvrement (1) et **en ce que** le joint d'étanchéité (7) est disposé de manière à générer un engagement par force entre le côté intérieur (4) et un dôme de ventilation (21) sur l'appareil sur lequel l'élément de fermeture peut être enfiché, ou un engagement par force entre le côté extérieur (5) et une ouverture de ventilation (19) sur l'appareil dans lequel l'élément de fermeture peut être enfiché.

5. Élément de fermeture perméable à l'air selon l'une quelconque des revendications 1 à 3, **caractérisé en ce que** le joint d'étanchéité (7) est disposé au niveau du côté intérieur (4) et **en ce que** le joint d'étanchéité (7) est disposé de manière à générer un engagement par force entre le côté intérieur (4) et un dôme de ventilation (21) sur l'appareil sur lequel l'élément de fermeture peut être enfiché.

6. Élément de fermeture perméable à l'air selon l'une quelconque des revendications 1 à 3, **caractérisé en ce que** le joint d'étanchéité (7) est disposé au niveau du côté extérieur (5) et **en ce que** le joint d'étanchéité (7) est disposé de manière à générer un engagement par force entre le côté extérieur (5) et une ouverture de ventilation (19) dans l'appareil dans lequel l'élément de fermeture peut être enfiché.

7. Élément de fermeture perméable à l'air selon l'une quelconque des revendications précédentes, **caractérisé en ce que** des éléments d'encliquetage (24) sont disposés sur le bord, lesquels correspondent à l'appareil, de telle sorte que l'élément de fermeture puisse être fixé à l'appareil, de telle sorte que les éléments d'encliquetage (24) soient disposés sur le côté extérieur (5) et correspondent à une arête (30) d'une ouverture de ventilation (19) dans l'appareil, opposée à l'élément de fermeture, à une contre-dépouille ou une rainure d'encliquetage dans l'ouverture ou **en ce que** les éléments d'encliquetage (24) sont disposés du côté intérieur (4) et correspondent à un bourrelet d'encliquetage ou une rainure d'encliquetage au niveau d'un dôme de ventilation (21).

8. Élément de fermeture perméable à l'air selon la revendication 7, **caractérisé en ce que** le bord (6) est pourvu au niveau de son côté inférieur (25), c'est-à-dire entre le côté intérieur (4) et le côté extérieur (5), d'un élément élastique (26).

9. Élément de fermeture perméable à l'air selon l'une quelconque des revendications précédentes, **caractérisé en ce que** l'espace de compensation (11) est divisé par une première nervure (13) située perpendiculairement au côté du couvercle (3), qui s'étend depuis le côté du couvercle (3) jusqu'au disque filtrant (10), et chaque partie de l'espace de compensation (11) est pourvue d'une ouverture de compensation (12).

10. Élément de fermeture perméable à l'air selon l'une quelconque des revendications précédentes, **caractérisé en ce que** le matériau du disque filtrant (10) est réalisé sous forme hydrophobe.

11. Élément de fermeture perméable à l'air selon l'une quelconque des revendications précédentes, **caractérisé en ce qu'**un côté intérieur (22) de l'élément de recouvrement (1) opposé au disque filtrant (10) présente une structure de surface à effet hydrophobe.

12. Élément de fermeture perméable à l'air selon l'une quelconque des revendications précédentes, **caractérisé en ce que** la distance entre le disque filtrant (10) et le côté du couvercle (3), c'est-à-dire la hauteur de l'espace de compensation (11), est choisie de manière à être supérieure au diamètre d'une goutte d'eau se formant dans cet espace (11).

13. Élément de fermeture perméable à l'air selon l'une quelconque des revendications précédentes, **caractérisé en ce que** la distance entre le disque filtrant (10) et le côté du couvercle (3), c'est-à-dire la hauteur de l'espace de compensation (11), diminue dans la direction radiale vers le centre de l'espace de compensation.

14. Élément de fermeture perméable à l'air selon la revendication 13, **caractérisé en ce que** le côté intérieur (22) du côté du couvercle (3) est réalisé sous forme cintrée ou conique dans la direction du disque filtrant (10).

15. Élément de fermeture perméable à l'air selon l'une quelconque des revendications 1 à 12, **caractérisé en ce que** l'élément de recouvrement (1) conjointement avec le joint d'étanchéité (7) est réalisé sous forme de pièce moulée par injection à deux composants.
